# EUROPEAN PATENT APPLICATION

(11) **EP 4 635 874 A1**
(43) Date of publication of application: **22.10.2025**
(21) Application number: 25171137.0
(22) Date of filing: 17.04.2025
(51) Int. Cl.: B65D 73/02, H05K 13/00, B65B 15/04, H05K 13/04, B65D 85/672

(54) **CARRIER STRIP WITH ELECTRICAL COMPONENTS AND METHOD FOR MANUFACTURING SUCH A CARRIER STRIP**

(30) Priority: 17.04.2024 DE 102024110786
(71) Applicant: TE Connectivity Solutions GmbH, 8200 Schaffhausen (CH)
(72) Inventor: SCHEER, Kevin, 8200 Schaffhausen (CH); ULRICH, Harald, 8200 Schaffhausen (CH)
(74) Representative: Grünecker Patent- und Rechtsanwälte PartG mbB

(57) **Abstract**

The invention relates to a carrier strip (1) with at least one strip-shaped layer (2) made from a plane material, with electrical components (12) that are arranged lying side by side in longitudinal direction (4) of the carrier strip (1). An embodiment of the carrier strip (1) comprises two stacked layers (2) made from plane material, such as paper material, extending in longitudinal direction (4) of the carrier strip (1). One of the two stacked layers (2) comprises a smaller width (6) than the other of the two stacked layers (2). The electrical components (12) are especially arranged between the two layers (2) and protrude from under one layer (2). The invention further relates to a method for manufacturing a carrier strip (1) with electrical components (12), comprising: arranging the electrical components (12) in longitudinal direction (4) lying side by side on at least one layer (2). An embodiment of the method comprises: stacking two layers (2) made from plane material, wherein the one layer (2a) comprises a smaller width (6) than the other layer (2b) transverse to the longitudinal direction (4); arranging the electrical components (12) between the two layers (2), wherein one section (58) of the electrical components (12) protrudes from under the layer (2a) with the smaller width (6a).

## Description

The present invention relates to a carrier strip with electrical components with at least one strip-shaped layer made from a plane material that extends in the longitudinal direction of the carrier strip, and to a method for manufacturing a carrier strip with electrical components.

Small electrical parts and components such as contacts are increasingly being mass-produced and installed. Thus, having several components available on a single strip is an advantage and is traditionally realized by means of so-called reels or blister packs. Copper is mostly used for reels, however, the use of copper leads to higher material costs. Blister packs or trays produce plastic waste. They also require a lot of space, are comparatively expensive to produce and often more difficult to automate.

Consequently, the underlying problem of the invention is to provide a carrier strip that is inexpensive and easy to produce.

The present invention solves this problem by means of a carrier strip with electrical components having at least one strip-shaped layer made from a plane material and extending in the longitudinal direction of the carrier strip, wherein the electrical components are arranged on the at least one layer lying side by side in the longitudinal direction of the carrier strip.

The invention further solves this problem by means of a method for manufacturing such a carrier strip with electrical components. The method includes arranging the electrical components in a longitudinal direction lying side by side on at least one layer.

This solution allows for good adaptability, since carrier strips made from plane material can easily be printed, embossed or produced in different shapes and sizes, and as a result, the solution also allows for versatile usability and easy reusability, which helps to reduce waste and environmental pollution.

The invention can be further improved by the following configurations, which are each preferred on their own and can be arbitrarily combined with each other. In this context, the following features can be used both to further develop a device and to further develop the method, irrespective of whether a feature is described in connection with a method or a device. For example, a device can be configured to carry out a method step and a method can carry out the function of a device feature.

The carrier strip may preferably have a second strip-shaped layer made from a plane material that extends in the longitudinal direction of the carrier strip and is stacked on the other strip-shaped layer.

One of the two stacked layers can comprise a smaller width than the other of the two stacked layers. The electrical components can be arranged in the longitudinal direction of the carrier strip, lying side by side between the two layers, wherein a section of the electrical components can protrude from under the one layer.

A plane material is a material that forms a wider surface and is flattened, such as paper-based material, plastic, metal products, textile products or other fiber materials.

In the embodiment of the carrier strip with two layers, the layers preferably consist of the same material or a plane material. Preferably, the material is a paper-based material. In other words, the plane material used to produce the carrier strip or at least one layer of the carrier strip can be a paper-based material. A paper-based material here refers to a plane material that consists primarily of plant fibers and is divided into paper, cardboard or paperboard depending on its density or strength. The appropriate material can be selected depending on the need for more flexibility and/or more stability. Due to the thin nature of the carrier strip, it can be rolled up onto a roll and used as a reel. For this purpose, a core in the middle, for example a cardboard roll, can be used to roll the carrier strip around this roll. This type of rolling enables compact and space-saving storage and efficient transportation of the electrical components. In particular, the electrical components can be arranged side by side in the longitudinal direction of the carrier strip.

Alternatively, the carrier strip can be folded transversely to the longitudinal direction of the carrier strip at a certain length - for example, but not exclusively, at half the length of the carrier strip. This facilitates further processing and transportation, thus avoiding the use of additional material. The carrier strip can be folded in such a way that part of the electrical components is directly opposite the other part of the components, as defined by the fold, so that one component each lies directly on another component on the other side of the fold. It is preferred to fold in such a way that the components located in a first folded section of the carrier strip lie in an area or space in which the electrical components in a second section of the carrier strip are spaced apart. Preferably, the distance between the components is then chosen to be exactly the same as the width of a component. The distance can depend on the handling or further processing and be adapted to it.

The at least one layer of the carrier strip preferably abuts one flat side of the electrical component. The at least one layer can have a variable width. Thus material can be saved if the width of the at least one layer is chosen to be less than the length of the components in the width direction of the carrier strip. In the two-layer configuration, the two layers of the carrier strip preferably abut one flat side of the electrical component each, preferably against two opposite flat sides of the thinner or flatter part of the electrical component. In this way, the entire carrier strip with the electrical components is used efficiently and in a space-saving manner. While one layer abuts one side of a component, preferably against the flat and/or thin side of the component, the second layer thus abuts the opposite side of the component, achieving a sandwich arrangement that better protects the components from damage during transport.

The components can lie on the layer with the greater width and/or protrude in the direction of the overhang of the layer with the greater width over the layer with the smaller width. The layer with the smaller width can thus be covered by the components, at least in sections, to ensure easier placement and removal of the components.

The components are preferably placed in identical alignment or orientation on one layer or alternatively between the layers. Consistent alignment, which requires little correction, simplifies and accelerates the further processing of the components and, in particular, can be automated. For example, the components can then be removed and further processed by automatic placement machines.

At least in an area between two adjacent electrical components, the carrier strip or the two layers of the carrier strip can be connected, in particular the two layers can be connected by a material bondbond. The two layers can be connected via a connection element, such as a thread or at least one rivet.

The two layers may be clinched, bonded, staked and/or riveted to each other at least in an area between two adjacent electrical components.

Clinching describes a method for joining components and/or materials without the use of an additional material. The connection is made by plastic deformation of the two stacked materials and/or components, which enables a fast and efficient connection. The two layers can be stacked and deformed by pressure so that the two layers are connected in a form-fitting and/or force-fitting manner.

When bonding, for example, an adhesive tape or an adhesive strip can be used. The two layers of the carrier strip can be connected to each other by a double-sided adhesive strip. In this case, the two layers of the carrier strip can only be bonded to each other in the free areas between the components. Here, the use of a different adhesive, for example a liquid adhesive, would also be conceivable.

In another configuration, the adhesive tape can be attached to the two layers of the carrier strip from the outside. Preferably, the adhesive tape is attached around a common edge, in particular along the common edge of the two layers extending in the longitudinal direction, and abuts one flat side of each layer. In this configuration, the adhesive tape can function as a hinge and allow easier folding and unfolding of the two layers of the carrier strip, for example to allow easier positioning or insertion of the components between the two layers. In an alternative configuration, the adhesive tape is applied to at least one short side of the carrier strip, in order to connect the two layers to one another, for example at the two ends of the carrier strip.

The layers can still be connected to each other without touching the component, for example by attaching them to each other using clamping. For this purpose, the components are preferably arranged spaced apart from each other. At least one rivet is then placed in the free area between two components. Two rivets are preferably used between two components. After riveting, the rivets can join the two layers in the intended free area so tightly that the component is sufficiently attached by this clamping and, for example, accidental falling out during transport is prevented. The layers can be riveted to each other, for example by pressure riveting. It is furthermore conceivable to use staples in the area between two components or to nail or fasten them with a stapler, for example. Furthermore, the two layers can be fastened without staples by hooking the folded edges of the two layers together to hold the two layers together.

Similarly, the two layers can be fixed by hot staking and, analogously to riveting, can be connected to each other. The layers can have precut holes or recesses for the rivets and/or plastic inserts. Preferably, the holes or recesses can be located between the components so as not to damage the components themselves.

The electrical components can be sewn, clinched, bonded, staked and/or riveted with at least one layer. In this case, the plastic insert and/or the rivet is either placed into the layer through the component or placed from the layer through the component. Preferably, the component already has a hole provided for this purpose. In another configuration, the components are located between the two layers and the fastening component penetrates both the two layers and the respective component. The holes of the respective layer and of the one component are preferably stacked congruently.

When bonding, the adhesive tape can be selected with such a length that areas of the adhesive tape are attached to the electrical components and other areas of the same adhesive tape are attached to at least one layer of the carrier strip, preferably the adhesive tape is attached to the two opposite longitudinal sides of a component in the longitudinal direction of the carrier strip at least at one layer. The adhesive tape can be removable or detachable, especially without a trace, so as not to alter or affect the electrical components.

The adhesive tape can also be attached between a layer of the carrier strip and a component. In particular, in the case of the configuration with the double-sided adhesive tape or a liquid adhesive, the electrical components can be attached to at least one layer, and the layers can be connected to one another.

The two layers can additionally or alternatively be sewn together, at least in areas. Here, too, the carrier strip can have precut holes or recesses through which at least one thread can be pulled and/or passed. Advantageously, the thread can also pass through the component or sew the components directly to a layer. For this purpose, for example, already existing holes in the components can be used, which are utilized and/or needed during manufacturing or further processing.

The two layers can be sewn in such a way that the components between the layers are also held by the thread. In this way, the two layers can be pulled closer together by the thread, thus holding the electrical components between the two layers. Another configuration provides that the thread be threaded into at least two opposite sides of a component, for example the two longitudinal sides, in at least one strip-shaped layer, and that the component be wrapped in such a way that it is held by the thread, in particular if there are no holes in the component itself that can be used for sewing. In this way, a component can be sewn with at least one layer. For example, several holes can be placed on at least one strip-shaped layer of the carrier strip around the outer contour of the component in order to attach the component to at least one layer and to thread it on opposite sides of the component. In this way, the component can be partially covered and held by a thread. The thread then presses the component against the layer. The degree of fixation can be variably adjusted during sewing. If the thread is pulled tight during sewing, the components are held more firmly to the carrier strip than if the thread is held comparatively loosely.

Preferably, the electrical components are sewn with at least one layer. In this case, a fabric thread, such as a wool thread and/or a synthetic thread, such as a nylon and/or polyester thread, in particular a filament thread, can be used, wherein filament describes a fiber of practically unlimited length, and the filament thread can thus be a thread of continuous material of practically unlimited length, which has a high tensile strength and can be antistatic.

At least one hole can be present in the component itself, preferably two holes are present in a component to sew the components to the carrier strip. In this case, a hole can be added at the height of the holes and recesses of the respective component and with approximately the same diameter on at least one layer, preferably two layers, to facilitate precise sewing. For example, when sewing, the holes can be created by piercing the carrier strip or the at least one layer with the needle used.

A sewn thread can extend in the longitudinal direction of the carrier strip over several electrical components. A thread is then sewn along the entire length of the carrier strip with the two layers and/or at least one layer and the electrical components. In this way, a continuous thread can be used. The seam then extends over electrical components and over spaces between the electrical components over the entire length of the carrier strip. The use of a continuous thread makes it easier to remove individual components and to dispose of the carrier strip and thread at a later stage. In an alternative configuration, individual shorter threads are used for each component to ensure independence between the individual components, for example when removing individual components. In this way, another component is not affected by the removal of a component.

At least one layer can have an embossing in which the electrical components are lying. Embossing is the formation of a physical object with elevations and/or depressions and their result. For example, embossing can create two opposing elevations, the distance between which corresponds to the width of a component in the longitudinal direction of the carrier strip. The elevations or boundaries extend in the width direction of the carrier strip. In addition, at least one elevation can have lugs or latching lugs that point towards the component located within the elevations and partially protrude over the component located within the elevations. In another configuration, there may be a further embossing and elevation on the short side of the component, which extends in the longitudinal direction of the carrier strip and corresponds approximately to the width of the inserted component in the longitudinal direction, in order to prevent the component from falling out transversely to the longitudinal direction of the carrier strip.

The embossing can be complementary to an outer contour of the electrical components. For this purpose, a stamp or embossing tool can be specially manufactured and used for embossing the outer contour of an electrical component. For example, this embossing stamp can be 3D printed and have the complementary outer contour of the component. Alternatively, the embossing stamp can have a recess for a component, an identical prototype of the electrical component, or a part with the same outer contour as the component, which can be inserted into it and thus used as an embossing stamp. In this way, the outer contour of the component can be embossed in the carrier strip and the component can fit, be inserted, and held in the resulting mold. This mold is preferably a depression.

Furthermore, it is possible that the component is held between two or more elevations or boundaries created by embossing the component's outer contour, and the two elevations have a sufficient distance in the longitudinal direction to place a component in them. In another configuration, the embossing stamp forms the above-mentioned approximately cuboid or linear elevations - which, in the width direction, correspond at least to the length of the component in the width direction and which, in the length direction, are spaced at a distance that corresponds to the width of a component in the length direction - on at least one layer.

According to a further embodiment, at least one further electrical component of the plurality of electrical components can be placed on the opposite side of the layer. In this way, two components can be directly opposite each other and only be separated from the carrier strip or a layer of the carrier strip. However, the components placed on opposite sides of the carrier strip can also be arranged offset to each other, so that a component is arranged on the other side between two components on one side of the layer. This is particularly preferred in combination with embossing, wherein the depression on one side of the layer can form the boundary for holding the component on the other side of the layer. This allows the layer or carrier strip to be used optimally and in a space-saving manner over its entire length.

The components can be completely covered by the two layers of the carrier strip. The components can just as easily be covered by an adhesive strip on one side and by a layer of the carrier strip on the other.

The two layers may be separate parts that are joined together by the various methods described above, such as clinching, sewing, riveting, bonding or staking. One of the edges of one of the layers extending in the longitudinal direction of the two layers can then be aligned with one of the edges of the other of the two layers extending in the longitudinal direction of the two layers. The two edges of the two layers extending in the longitudinal direction then lie on top of each other. It is preferred that the two layers end at a common plane that extends parallel to the longitudinal direction and is perpendicular to the width direction of the carrier strip, and the edges are preferably in the same plane. This has the advantage of easy manufacturing and alignment of the electrical components to ensure the same or similar alignment.

Similarly, one of the two layers can be formed by a flap or, equivalently, a doubling of a fold in the carrier strip. In this configuration, the two folded layers are monolithic, in particular connected by a fold. The fold can be created by folding and the two layers can be connected to each other. In another configuration, the fold can connect the two layers in a form-fitting manner. The fold makes additional fastening options and materials redundant.

For manufacturing the carrier strip, the method can comprise the following steps: stacking two layers made from plane material, wherein one of the two layers has a smaller width than the other layer transverse to the longitudinal direction; arranging the electrical components lying side by side in the longitudinal direction between the two layers, wherein one section of the electrical components protrudes from under the layer with the smaller width.

The method step of arranging the electrical components between the two layers comprises placing the electrical components between the two layers or stacking the two layers with the electrical components interposed therebetween.

Furthermore, the method may comprise: bonding the electrical components to at least one layer. In one embodiment, the method comprises bonding the two layers together.

In addition, the method, in particular with the configuration of the carrier strip with two layers, can include the combined method step of connecting the two layers to each other and connecting the electrical components to at least one layer. In particular, the two layers can be connected in the area in which they are stacked, for example in addition to or instead of a fold.

The method step of connecting the electrical components with at least one layer and/or the two layers to each other comprises at least one of the following method steps:
sewing the two layers together;
sewing the electrical components to at least one layer;
bonding the two layers together;
bonding the electrical components to at least one layer;
riveting the two layers together;
riveting the electrical component to at least one layer;
staking the two layers together;
staking the electrical components with at least one layer;
clinching the two layers together;
clinching the electrical component with at least one layer.

The method step of stacking the two layers can be created by folding a starting strip. The one layer can then form a flap. When folded, the two layers are connected at one edge. Stacking the two layers involves stacking two separate layers, which can then be clinched, riveted, bonded or sewn together.

In the following, the invention is described with reference to the drawings by means of an embodiment. Thereby, the same reference signs are always used in the drawings for elements that correspond to each other in terms of function and/or structure.

In accordance with the description above, a feature of the embodiment can be omitted if the technical effect associated with that feature is not relevant to a particular application. Conversely, a feature not yet present in the embodiment can also be added to the embodiment according to the description above if the technical effect of the feature to be added is relevant to a particular application.

It is shown by:
- Fig. 1: a representation of a configuration of the carrier strip;
- Fig. 2: a representation of a configuration of the carrier strip with electrical components and individual threads;
- Fig. 3: a representation of a configuration of the carrier strip with electrical components and threads;
- Fig. 4: a side view of a configuration of the carrier strip with electrical components;
- Fig. 5: a schematic representation of a configuration of the carrier strip with electrical components with a continuous thread;
- Fig. 6: a representation of a configuration of the carrier strip with electrical components with an adhesive tape;
- Fig. 7: a side view of a configuration of the carrier strip with electrical components with an adhesive tape;
- Fig. 8: a representation of a configuration of the carrier strip with electrical components with rivets;
- Fig. 9: a representation of a configuration with staking of the carrier strip with electrical components;
- Fig. 10: a representation of a configuration of the carrier strip with only one layer;
- Fig. 11: a representation of a configuration of the carrier strip with embossing;
- Fig. 12: a schematic view of the inside of the embossing;
- Fig. 13: a schematic view of the outside of the embossing;
- Fig. 14: a top view of the embossing; and
- Fig. 15: a representation of a configuration of the rolled-up carrier strip.

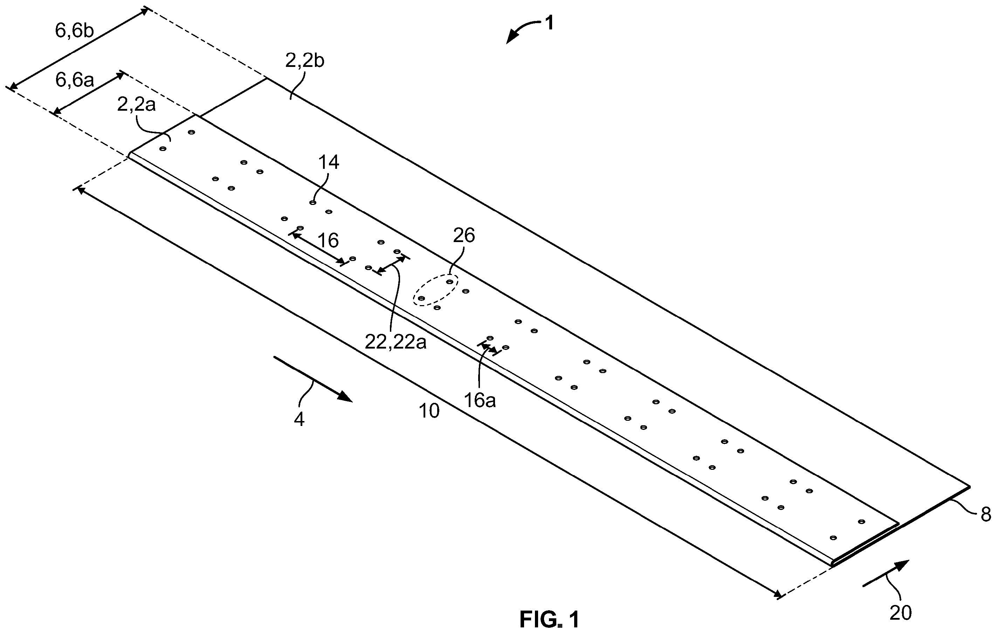

In Fig. 1, the carrier strip 1 comprises two strip-shaped layers 2 extending in the longitudinal direction 4 of the carrier strip 1 and stacked one above the other. The width 6a of the layer 2a, that is, the dimension of the layer 2 transverse to the longitudinal direction 4, is less than the width 6b of the other layer 2b.

The carrier strip 1 can be made from a plane material, such as paper-based material. The carrier strip 1 can thus be made from paper, paperboard or cardboard of various thicknesses. Alternatively, the carrier strip 1 can be made from plastic, metal products, textile products or other fibrous materials, for example. Preferably, the two layers 2 are made from the same material. In an alternative embodiment, the two layers 2 are made from different material. In the embodiment in Fig. 1, the carrier strip 1 is configured such that one layer - or also, a fold or doubling - 2a is folded over the other layer 2b.

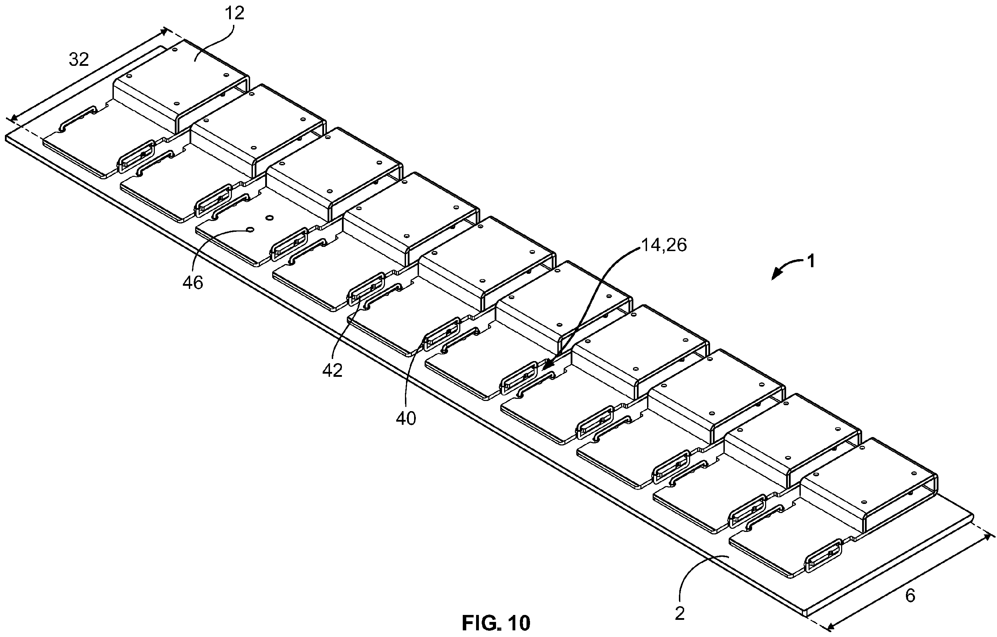

In one configuration, the carrier strip 1 consists of only one layer 2 made from a plane material, as shown in Fig. 10 and described in more detail below. The embodiments described below and the associated advantages for the configuration of the carrier strip 1 with two layers 2 apply equally - where applicable - to a carrier strip with only one layer 2.

The carrier strip 1 comprises a material thickness 8, the dimension of which is significantly less than the length 10 of the carrier strip 1 and also significantly less than the width 6 of the carrier strip 1. The material thickness 8 can be variably adjusted for different applications and, for example, can be chosen to be thicker for greater stability.

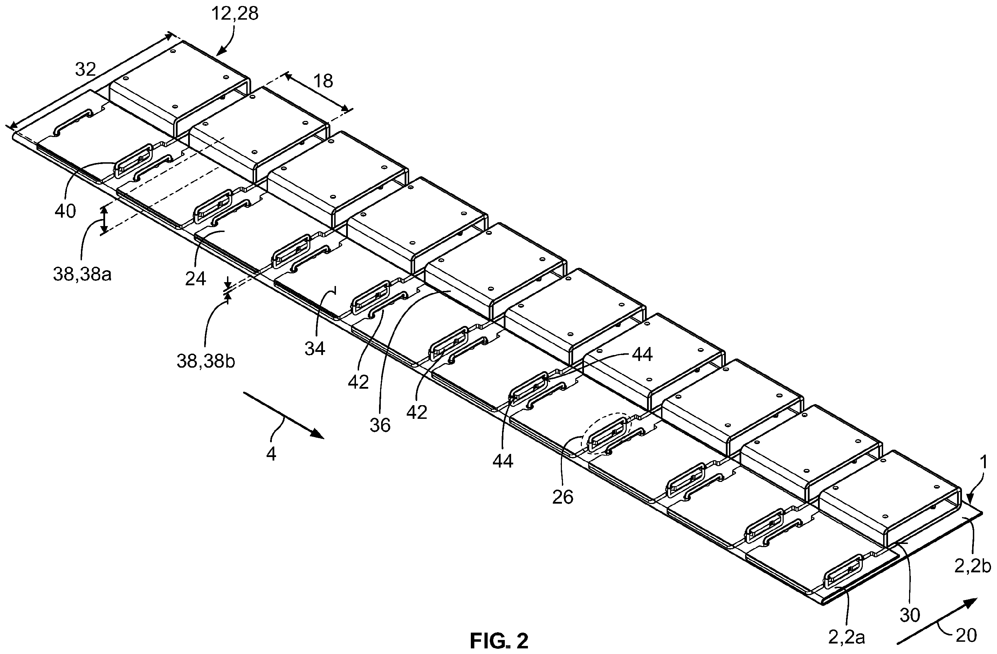

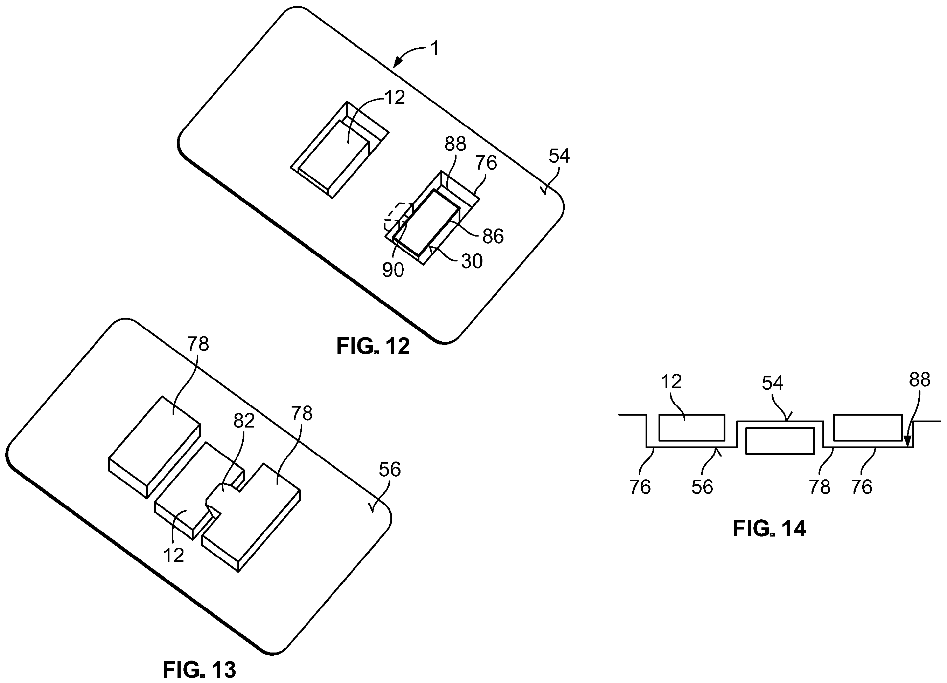

In this case, carrier strip 1 can have a certain length 10 and be of such a length that several components 12 (Fig. 2) can be arranged side by side. Furthermore, the length 10 can be selected such that the entire carrier strip 1 can be rolled up together with the electrical components 12, as shown in Fig. 14.

In the example shown in Fig. 1, on at least one layer 2 there are holes or recesses 14 through which, for example, the two layers 2 can be connected to one another. The holes 14 can also be used to fix the electrical components 12.

The holes 14 may be spaced apart, preferably they are spaced apart at a distance 16 which corresponds approximately to the width 18 (Fig. 2) of a component 12. In the width direction 20, the carrier strip 1 can also have holes 14. In this representation, the carrier strip 1 has at least two holes 14 on a line parallel to the width direction 20, which are spaced apart from one another at a distance 22. The distance 22 can correspond to an existing hole pattern on the component 12 or at least be at the height of a part of the component 12, preferably a flatter part 24 (Fig. 2) of the component 12, and for example have a distance 22a. In the longitudinal direction 4, a plurality of such pairs of holes 26 can be arranged side by side and each be spaced apart from one another by the distance 16, which corresponds to the width 18 of a component 12. A smaller distance 16a can be selected between two components 12 in order to save space or to fully utilize the space on the carrier strip 1.

Fig. 2 shows an embodiment of the carrier strip 1 with several electrical components 12 arranged side by side, wherein the electrical components 12 all have the same alignment 28 and orientation and the longitudinal side 30 of a component 12 is approximately parallel to the width direction 20 of the carrier strip 1. A layer 2b of the carrier strip 1 is preferably the same width or slightly wider than the length 32 of the electrical component 12 extending in the width direction 20. The other layer 2a is preferably folded over the flat side 34 of the electrical component 12 and can, as shown in Fig. 2, abut a shoulder 36 of the electrical component 12 which may have a greater thickness 38a than the thickness 38b of the flat part 24, over which the layer 2a is folded and which is covered by the layer 2a. In this way, the carrier strip 1 can be kept as flat as possible in the dimension perpendicular to the longitudinal direction 4. Since the components 12 extend beyond the layer 2a with the smaller width 6a, the components can be more easily removed or placed between the layers 2.

In this embodiment, the electrical components 12 are each attached to the two layers 2 by two short threads 40. In this context, each electrical component 12 can have two opposing lugs 42. The two lugs 42 can protrude in the longitudinal direction 4 of the carrier strip 1 away from the two longitudinal sides 30 of the electrical component 12. At the front sides 44 of a lug 42 pointing in the width direction 20, a pair of holes 26 can be located, through which a thread 40 can be passed, which sews the layer 2a placed on top to the layer 2b lying below and the component 12 is thus held in a preferred manner on the respective lug 42. The two layers preferably have two congruent pairs of holes 26 to facilitate sewing. Of course, components 12 that do not have lugs 42 or projections can also be sewn.

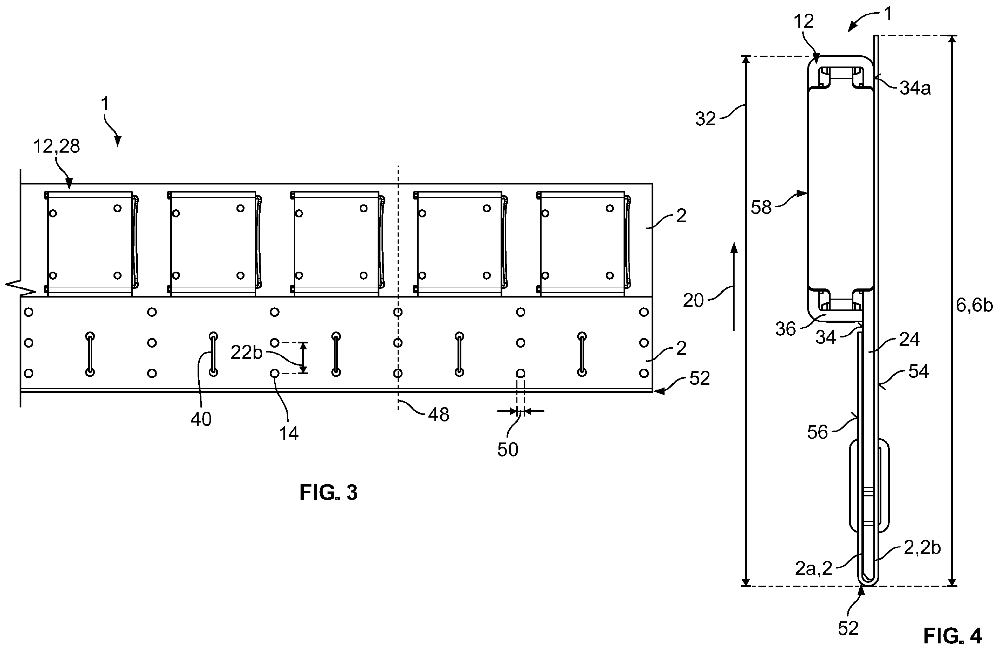

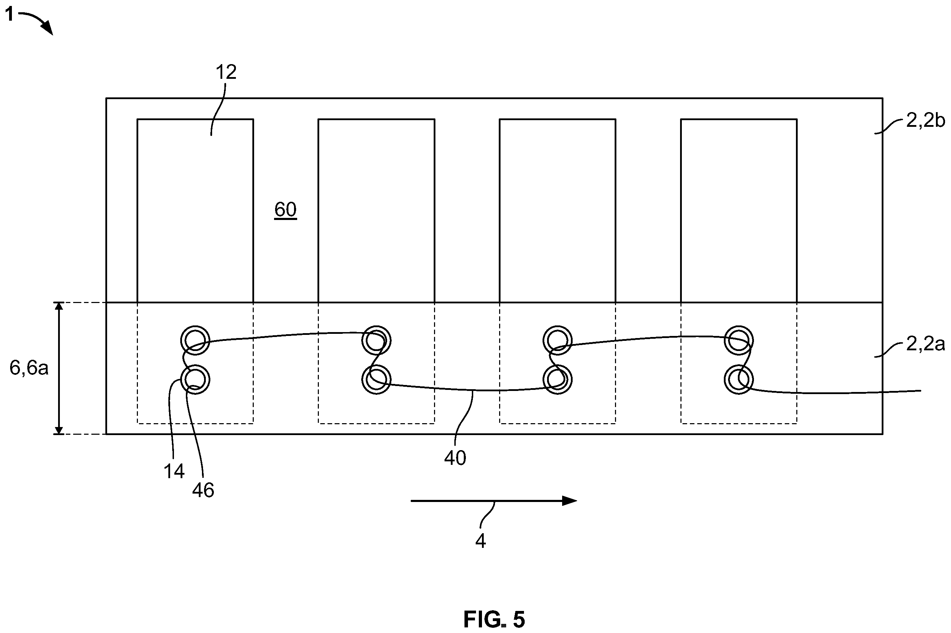

Fig. 3 shows an embodiment of the carrier strip 1 with several electrical components 12, wherein the electrical components 12 are fixed with several individual threads 40. In the example shown, each thread 40 passes through the layers 2 and through the component 12 itself. For this purpose, the component 12 can have holes 46 (Fig. 5). This means that fewer threads 40 are required.

Between the components 12, the carrier strip 1 can have further holes 14 for fixing the two layers 2 together. Preferably, the holes 14 and the pair of holes 26 (Fig. 1) are arranged parallel to the width direction 20 on a line 48 and have a distance 22b, which may be smaller than the distance 22a of the pair of holes 26. The distance 22, 22b can be variable and adapted to the respective connection method. Thus, the distance 22b can also be the same as the distance 22a. The diameter 50 of the hole 14 can also be varied depending on the connection method.

Preferably, the electrical components 12 are placed between the two layers 2 so that the holes 46 of the component 12 are lying directly under the holes 14 of the carrier strip 1. This ensures that the alignment 28 of the components 12 is the same or similar for all components 12.

In this embodiment, the thread 40 is threaded into the hole 14 that is closer to the fold or crease 52 of the carrier strip 1 and pulled through, for example, on the underside 54 (Fig. 4), into the hole 14, which is further away from the fold 52, of the pair of holes 26. On one side, for example the top side 56, both thread ends of the thread 40 can be tied together, whereby the component 12 is attached to the two layers 2. Similarly, the thread 40 can be tied to the underside 54 of the carrier strip 1, for example, to fix the component 12. This process can then be carried out individually for each component 12 on the carrier strip 1.

Fig. 4 shows a side view of a further embodiment of the carrier strip 1 with at least one electrical component 12. In this illustration, the carrier strip 1 has a fold 52 with layers 2 which abut the component 12. In particular, the electrical component 12 can have a thinner or flatter part 24, against which the carrier strip 1 nestles or to which the two layers 2 of the carrier strip 1 nestle on the respective flat side 34. In this way, the flatter part 24 in particular is covered. The remaining part 58, which can lie seamlessly in the widthwise direction 20 against the flatter part 24, is configured thicker in this example and lies against a layer 2 on one side 34a only.

The width 6b of layer 2b can be slightly longer than the length 32 of component 12. In this configuration, the layer 2a does not directly abut the shoulder 36 of component 12 and is spaced apart from the shoulder 36.

The thread 40 can pass through the flatter part 24 of the component 12 and through the two layers 2 to connect the carrier strip 1 and the component 2 together.

Fig. 5 shows an alternative method of sewing. In this example, the electrical components 12 also lie side by side on one layer 2b, while the other layer 2a lies on the opposite flat side 34 of the component 12 and partially covers the component 12 (the covered part of the component 12 is shown here as a dashed line). The electrical components 12 may have holes 46 as shown here, which may be congruent with holes 14 in at least one layer 2, for example the holes 46 of the component 12 are directly below the holes 14 of the layer 2a with the smaller width 6a.

Advantageously, the other layer 2b can also congruently have holes 14 under the holes 46 of the component 12. A continuous thread 40 can then be threaded through these holes 14, which extends in the longitudinal direction 4 of the carrier strip 1 over the entire carrier strip 1 and is spanned over several components 12 and spaces 60. This means that the electrical components 12 can be attached to the carrier strip 1 with only one thread 40, which saves material and simplifies the separation of the carrier strip 1 and thread 40.

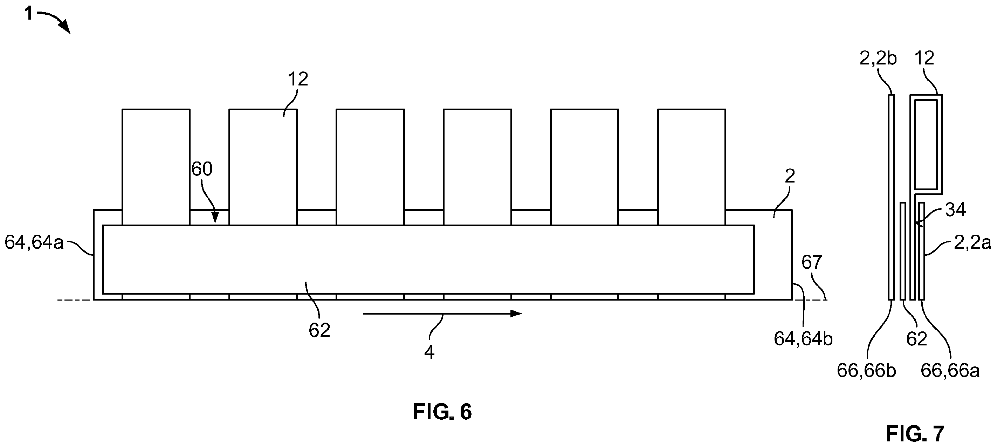

Fig. 6 shows an embodiment of the carrier strip 1 with an adhesive strip 62. In the shown example, the carrier strip 1 has an area or space 60 in which two electrical components 12 are spaced apart. The adhesive strip 62 can run in the longitudinal direction 4 from one end 64a of the carrier strip 1 to the other end 64b of the carrier strip 1. In a further configuration, the adhesive strip 62 can bond the one layer 2 to the other layer 2, in particular in the area 60. The adhesive tape 62 can be double-sided for this purpose.

The electrical components 12 can be held exclusively by the adhesive strip 62 on at least one layer 2 of the carrier strip 1. In this case, the use of a liquid adhesive is also conceivable or a single-sided adhesive tape 62. Preferably, the adhesive can be removed completely and without trace from the component 12, so as not to negatively affect the quality of the component 12. In the embodiment with only one layer 2, the components 12 can be arranged between the layer 2 and an adhesive strip 62. Alternatively, at least one adhesive strip 62 or adhesive lies between the layer 2 and the at least one component 12 and bonds the at least one component 12 to the layer 2.

Fig. 7 shows a side view of a configuration with the adhesive strip 62, wherein the adhesive strip 62 can be located between the component 12 and the layer 2b of the carrier strip 1 with the greater width 6b.

In this representation, the two layers 2 are not connected to one another. The two edges 66 of the layers 2 can be aligned with one another and can be connected to one another, for example, by the adhesive strip 62. The two edges 66 preferably extend in the longitudinal direction 4 and can both abut the same parallel line to the longitudinal direction 4. In particular, the edge 66a of layer 2a with the smaller width 6a can be or end in the same plane 67 (Fig. 6) as the edge 66b of layer 2b. The plane 67 extends in the longitudinal direction 4 and is perpendicular to the width direction 20 of the carrier strip 1.

The electrical component 12 can be inserted between the two layers 2 with the flat side 34 facing the carrier strip 1. Preferably, the electrical component 12 also adheres to at least one of the two layers 2. Alternatively or cumulatively, the two layers 2 are connected to each other by a fold 52 (Fig. 4) and the adhesive strip 62 can serve primarily to secure the components 12. The adhesive strip 62 can be used to connect both the components 12 and the two layers 2 to each other for greater stability and security, in particular in the configuration with the fold 52 of the carrier strip 1.

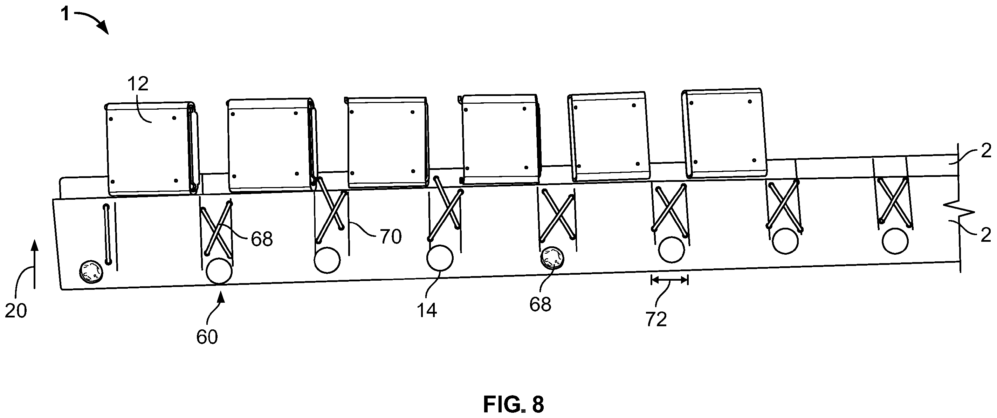

Fig. 8 shows an embodiment of the carrier strip 1 with electrical components 12, which is riveted. In this case, the two layers 2 can be riveted to one another. The layers 2 can be riveted to one another in the area 60 in which the two electrical components 12 are spaced apart from one another. For example, staples 68 or pressure rivets 68 can be used for this purpose. The staples 68 can be pressed in parallel to the width direction 20, so that only one staple 68 is needed. At least two rivets 68 can also be used per space 60 to connect the layers 2 to one another and to fix the components 12 by clamping on both longitudinal sides 30 of the component 12.

In this embodiment, the components 12 are not contacted and/or damaged by the rivets 68. Preferably, at least one layer 2 has holes 14 for orientation between two components 12 and/or markings 70 in the form of lines to ensure correct spacing 72. Further possibilities for riveting can be a nailing or fastening with, for example, a stapler. Another configuration can have a staple-less fastening of the two layers 2 together. In this case, instead of a staple, folded edges and/or parts of the layers 2 are hooked or intertwined with each other to hold the two layers 2 together.

In a further embodiment, the components 12 can be riveted to the layer 2 and/or attached to the layer 2 with rivets or staples 68. For example, a staple 68, which has a length that is greater than the width 18 of the component 12 in the longitudinal direction 4 of the carrier strip 1, can be attached parallel to the longitudinal direction 4 directly above the component 12 and be pressed against two sides of the component 12, preferably two sides lying opposite one another in the longitudinal direction 4, by the layer 2 in order to secure the component 12 to the layer 2.

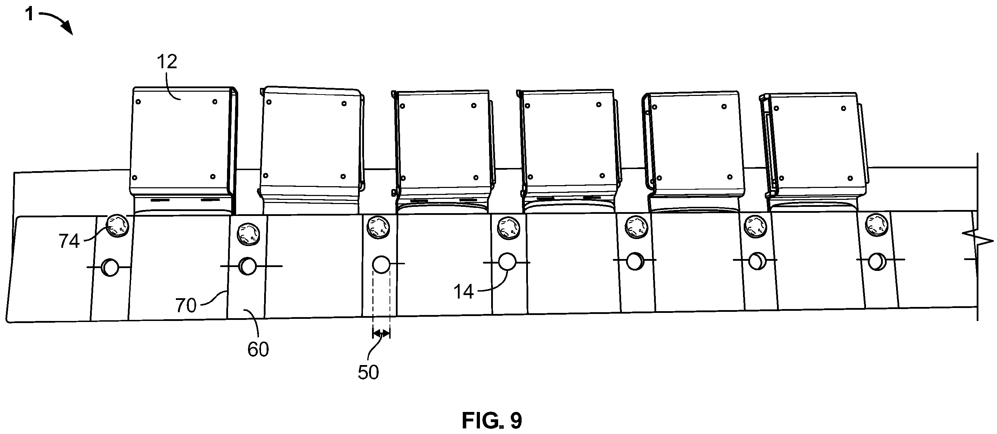

Fig. 9 shows an embodiment with staking of the two layers 2 of the carrier strip 1. It is preferred that the carrier strip 1 has at least one, and preferably two holes 14 in the width direction 20 with a diameter 50, in order to insert the plastic inserts 74. Here, too, the layer 2 can have markings 70 to ensure correct placement of the components 12 before staking.

The two layers 2 can be staked together by placing the respective plastic insert 74 in the hole 14 and deforming it in the hole 14 by applying force and heat. The components 12 can remain unaffected by the staking process. Preferably, two plastic inserts 74 are used for each area 60. Alternatively, the components 12 can be staked with layer 2.

In a further configuration, the two layers 2 can be connected to each other without any additional material, for example by clinching. In this way, pressure can be exerted on the two layers 2, for example in the area 60 between the components 12, in order to deform the two layers 2 in the area 60 and, for example, to connect them to one another in a form-fitting manner. At least one component 12 can be clinched to at least one layer 2.

Fig. 10 shows an embodiment of the carrier strip 1 with only one layer 2. The components 12 are arranged side by side on layer 2 of the carrier strip 1 and attached to layer 2 of the carrier strip 1. The carrier strip 1 can be configured to have a width 6 that corresponds approximately to the length 32 of the component 12, which allows for easier arrangement and manufacturing of the carrier strip 1.

In an alternative embodiment, the carrier strip 1 can have a smaller width 6 than the length 32 of the component 12. For example, the carrier strip 1, in particular the layer 2 of the carrier strip 2, can have a width 6 that is just wide enough to ensure that the components 12 are securely attached to the layer 2, in order to obtain a compact carrier strip 1 that saves both material and space.

The components 12 can be analogously attached to the layer 2 with threads 40 as in the configurations already mentioned. One thread 40 each can be guided through at least one hole 14, preferably through a pair of holes 26, in the layer 2 and wrapped around a lug 42 of the component 12. By pulling it tight, the component 12 is pulled onto the layer 2 and fixed there. Alternatively, a thread 40 can be guided both through the component 12, for example through a hole 46 in the component, and through the layer 2. The layer 2 does not necessarily have to have a hole 14 from the outset. The at least one hole 14 can be created, for example, by a needle when threading. Alternatively, a longer thread 40, as for example in the embodiment of Fig. 5, can be threaded through the carrier strip 1 and the components 12 in order to fix the components 12.

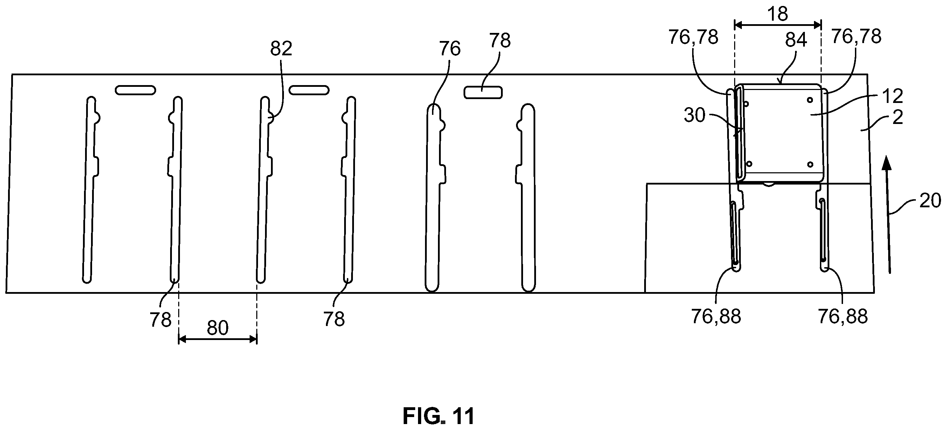

In Fig. 11, the layer 2 is shown in an embodiment with embossing 76. The layer 2 can have at least two elevations 78 that protrude on both longitudinal sides 30 of an electrical component 12, preferably with a distance 80 that corresponds to the width 18 of the component 12, so that the electrical component 12 fits between these two boundaries 78 and is held in place by the boundaries 78. A preferred embodiment provides lugs or latching lugs 82 in the embossing 76 to additionally secure the component 12 inserted therein.

Furthermore, a further limitation 78 can be embossed on the front side 84 of the component 12 to prevent the component 12 from falling out in the width direction 20. After inserting the component 12 into the embossing 76, the component 12 and the layer 2 or, in the case of the configuration with two layers 2, the component 12 and the two layers 2 can additionally be connected to one another by clinching, staking, sewing or riveting.

Fig. 12 shows an example of an inside of an embossing 76, for example on the underside 54 of the carrier strip 1, which corresponds to the outer contour 86 of the component 12. This allows a component 12 to be inserted into the resulting depression 88. This depression 88 can also advantageously have at least one recess 90, which points away from at least one longitudinal side 30 of the component 12, for example to allow easier removal of the component 12 from the depression 88.

Fig. 13 shows an embodiment of the side opposite the inner side in Fig. 12, for example the top side 56 of the carrier strip 1. The two elevations 78, which are pockets or depressions 88 for two electrical components 12 on the other, inner side 54, can form boundaries 78 for a further electrical component 12 on this, outer, side 56. The at least one recess 90 on the inside 54 can now serve as an additional means of securing or as a lug 82 for the electrical component 12 on this outer side 56.

Fig. 14 shows a top view of an embodiment of the embossing 76 from Figs. 12 and 13. Preferably, the electrical component 12 lies on one side, for example on the top side 56, between the elevations 78 of two electrical components 12 of the other side, corresponding to the underside 54. The embossings 76 and the depressions 88 of the two electrical components 12 on, for example, the underside 54 serve, in the illustrated example, on the other side, the top side 56, as a boundary 78 for the at least one other component 12.

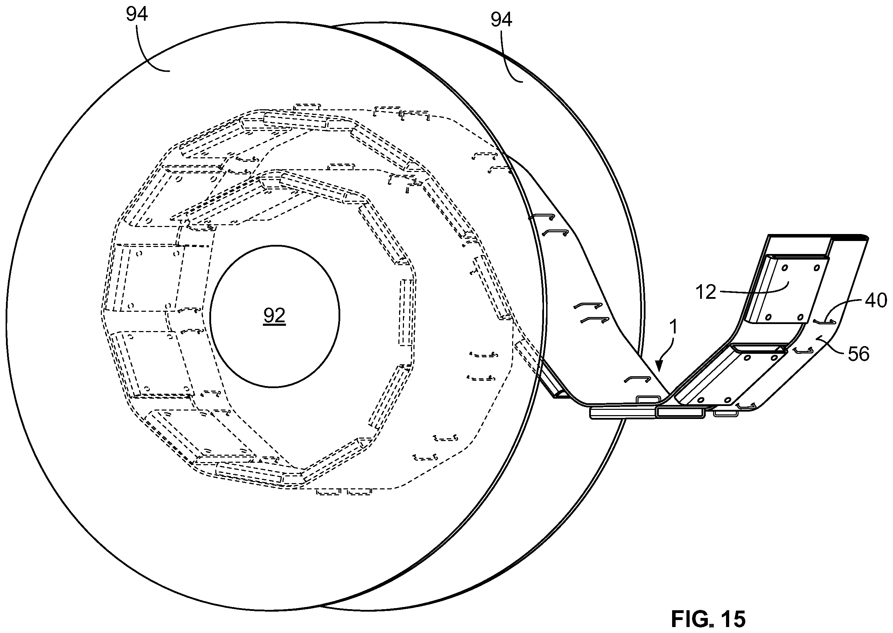

Fig. 15 shows an embodiment of the carrier strip 1 with electrical components 12, which is rolled up. In this context, the representation shows a core 92, such as a cardboard tube, around which the carrier strip 1 is rolled. The components 12 can thereby be attached on one side, for example the top side 56 of the carrier strip 1, by means of one of the above-mentioned connection methods. For example, the components 12 are sewn to the carrier strip 1 with the thread 40. The components 12 can be fixed to a single layer 2 of the carrier strip 1 or, alternatively, can be arranged between two layers 2.

The carrier strip 1 can then be rolled around the core 92 with the components 12 pointing towards the core 92. The core 92 can have two walls 94, against which the carrier strip 1 can abut on its longer sides.

### Reference signs

- 1: carrier strip
- 2, 2a, 2b: layer
- 4: longitudinal direction of the carrier strip
- 6, 6a, 6b: width of the carrier strip
- 8: material thickness
- 10: length of the carrier strip
- 12: component
- 14: hole/recess
- 16, 16a: distance of holes in longitudinal direction
- 18: width of a component
- 20: width direction of the carrier strip
- 22, 22a, 22b: distance of holes in width direction
- 24: flatter part of the component
- 26: pair of holes
- 28: alignment of the component
- 30: longitudinal side of the component
- 32: length of the component
- 34, 34a: flat side of the component
- 36: shoulder of the component
- 38, 38a, 38b: thickness of the component
- 40: thread
- 42: lug
- 44, 44a, 44b: front side of the lug
- 46: hole in the component
- 48: parallel line
- 50: diameter of hole
- 52: fold of the carrier strip
- 54: underside of the carrier strip
- 56: top side of the carrier strip
- 58: thicker part of the component
- 60: space between two components
- 62: adhesive tape, adhesive strip
- 64, 64a, 64b: end of carrier strip
- 66, 66a, 66b: edge of strip-shaped layer
- 67: plane perpendicular to width direction
- 68: staple, rivet
- 70: marking
- 72: spacing
- 74: plastic insert
- 76: embossing
- 78: elevation, boundary
- 80: distance
- 82: lug, latching lug of embossing
- 84: front side of the component
- 86: outer contour of the component
- 88: depression
- 90: recess
- 92: core
- 94: wall

## Claims

1. Carrier strip (1) with electrical components (12),
with at least one strip-shaped layer (2) made from a plane material, which extends in the longitudinal direction (4) of the carrier strip (1), wherein
the electrical components (12) are arranged on the at least one layer (2) lying side by side in the longitudinal direction of the carrier strip (1).

2. Carrier strip (1) according to claim 1,
with a second strip-shaped layer (2) made from a plane material, which extends in the longitudinal direction (4) of the carrier strip (1) and is stacked on top of the other strip-shaped layer (2),
wherein one of the two stacked layers (2) has a smaller width (6) transverse to the longitudinal direction (4) than the other of the two stacked layers (2), wherein
the electrical components (12) are arranged between the two layers (2) lying side by side in the longitudinal direction (4) of the carrier strip (1), and wherein a section (58) of the electrical components (12) protrudes from under the one layer (2).

3. Carrier strip (1) according to claim 1 or 2, wherein the plane material is a paper-based material.

4. Carrier strip (1) according to claim 2 or 3, wherein the two layers (2) are clinched, bonded, staked and/or riveted to one another at least in an area (60) located between two adjacent electrical components (12).

5. Carrier strip (1) according to one of claims 2 to 4, wherein the two layers (2) are sewn to one another at least in areas.

6. Carrier strip (1) according to one of claims 1 to 5, wherein at least one layer (2) comprises an embossing (76) in which at least one electrical component (12) is located.

7. Carrier strip (1) according to one of claims 1 to 6, wherein the electrical components (12) are sewn, clinched, bonded, staked and/or riveted to the at least one layer (2).

8. Carrier strip (1) according to one of claims 1 to 7, wherein a sewn thread (40) extends in the longitudinal direction (4) of the carrier strip (12) over a plurality of electrical components (12).

9. Carrier strip (1) according to one of claims 2 to 8, wherein the two layers (2) are separate parts.

10. Carrier strip (1) according to one of claims 2 to 8, wherein at least one of the two layers (2) is formed by a flap (2a) of a fold (52) of the carrier strip (1).

11. Carrier strip (1) according to one of claims 2 to 10, wherein the two layers (2) are connected to one another by means of a fold (52).

12. Method for manufacturing a carrier strip (1) with electrical components (12), comprising:
- arranging the electrical components (12) in the longitudinal direction (4) lying side by side on at least one layer (2).

13. Method according to claim 12, further comprising:
- stacking two layers (2) made from a plane material, wherein the one of the two layers (2a) comprises a smaller width (6) transverse to the longitudinal direction (4) than the other layer (2b);
- arranging the electrical components (12) in the longitudinal direction (4) lying side by side between the two layers (2), wherein a section (58) of the electrical components (12) protrudes from under the layer (2a) of smaller width (6b).

14. Method according to one of claims 12 or 13, further comprising:
- connecting the electrical components (12) to at least one layer (2).

15. Method according to claim 14, wherein the method step of connecting the electrical components (12) to at least one layer (2) comprises at least one of the following method steps:
- sewing the two layers (2) together;
- sewing the electrical components (12) to at least one layer (2);
- bonding the two layers (2) together;
- bonding the electrical components (12) to at least one layer (2);
- riveting the two layers (2) together;
- riveting the electrical components (12) to at least one layer (2);
- staking the two layers (2) together;
- staking the electrical components (12) with at least one layer (2);
- clinching the two layers (2) together;
- clinching the electrical components (12) with at least one layer (2).
